# EUROPÄISCHE PATENTSCHRIFT

(11) **EP 0 475 179 B1**
(45) Veröffentlichungstag und Bekanntmachung des Hinweises auf die Patenterteilung: **08.06.1994**
(21) Anmeldenummer: 91114267.7
(22) Anmeldetag: 26.08.1991
(51) Int. Cl.: H05K 9/00

(54) **Steckverbinder für Rückwand-Verdrahtungen**
Plug connector for rear panel wiring
Connecteur multibroches pour câblages de panneaux-arrière

(30) Priorität: 04.09.1990 DE 9012637 U
(43) Veröffentlichungstag der Anmeldung: 18.03.1992
(73) Patentinhaber: SIEMENS AKTIENGESELLSCHAFT, 80333 München (DE)
(72) Erfinder: Thom, Günther, W-8035 Gauting (DE); Zell, Karl, Dipl.-Ing., W-8130 Niederpöcking (DE)

(56) Entgegenhaltungen:
- EP-A- 0 401 418
- DE-A- 3 537 669
- US-A- 3 904 810

## Beschreibung

Die Erfindung betrifft einen Steckverbinder für Rückwandverdrahtungen, bestehend aus einer als einseitig offenes rechtwinkeliges Gehäuse ausgebildeten Messerleiste zum Aufstecken auf die Messer einer Rückwandleiterplatte und einer in die Messerleiste einsteckbaren mit Aufnahmekammern versehenen und mit einer Baugruppenleiterplatte festverbundenen Federleiste, wobei die Messer und Federn parallel in mehreren Reihen angeordnet sind.

Derartige aus Messer- und Federleiste bestehende Steckverbinder sind allgemein bekannt. Bekannte Steckverbinder dieser Art weisen ein Grundraster von 2,5 mm auf und können sehr hochpolig ausgeführt werden. Dabei kann es bei einer hohen Steckpunktdichte zwischen den Steckpunkten sowohl zu kapazitiven als auch induktiven Verkopplungen kommen, wodurch die Übertragungsgüte der zu übertragenden elektrischen Signale beeinträchtigt wird.

Aufgabe der vorliegenden Erfindung ist es, einen Steckverbinder der eingangs genannten Art anzugeben, bei welchem Steckpunkte sowohl kapazitiv als auch induktiv entkoppelt sind.

Diese Aufgabe wird für einen Steckverbinder der oben genannten Art dadurch gelöst, daß in jeweils vorgegebenen Abständen quer zur Längsachse des Steckverbinders ein kammähnliches Schirmblech angeordnet ist, dessen Zinken in nebeneinanderliegende Aufnahmekammern der Federleiste hineinragen, und das stiftartige Vorsprünge aufweist, die in gleicher Weise wie die Kontaktelemente in Bohrungen der Baugruppenleiterplatte eingesetzt sind.

Dadurch, daß zwischen einer vorgebenen gewünschten Anzahl von Steckpunkten, die elektrische Signalpotentiale führen, ein mit Erdpotential verbundenes Schirmblech angeordnet ist, wird erreicht, daß die mit elektrischen Signalen beaufschlagten Steckpunkte untereinander sowohl kapazitiv als auch induktiv wirksam entkoppelt sind.

Im folgenden wird die Erfindung anhand eines in der Zeichnung dargestellten Ausführungsbeispiels näher erläutert.

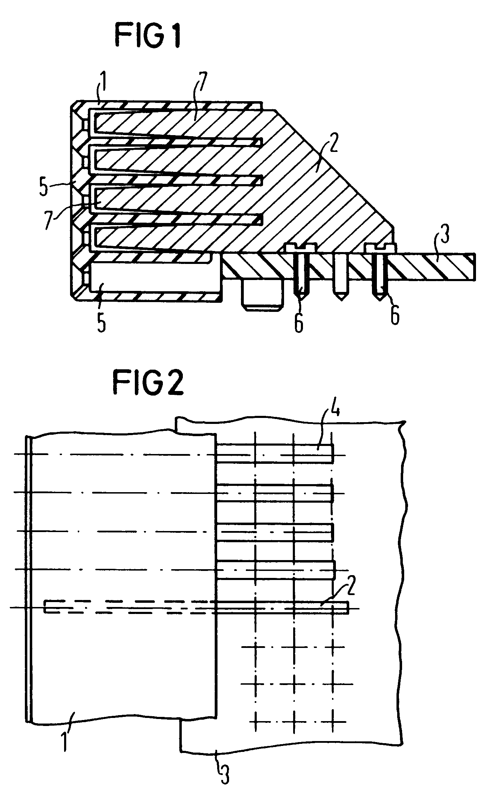

Es zeigen
- Figur 1: einen Querschnitt durch eine Federleiste eines gemäß der vorliegenden Erfindung aufgebauten Steckverbinders, und
- Figur 2: eine teilweise Draufsicht auf eine Federleiste eines erfindungsgemäßen Steckverbinders in Verbindung mit einem Teil einer Baugruppenleiterplatte.

In der Zeichnung sind nur die zum Verständnis der Erfindung notwendigen Bauteile eines Steckverbinders für Rückwandverdrahtungen gemäß der vorliegenden Erfindung dargestellt.

Die in der Zeichnung dargestellte Federleiste 1 ist fest mit einer Baugruppenleiterplatte 3 verbunden. Die Federleiste 1 weist in bekannter Weise Aufnahmekammern 5 für Kontaktelemente 4 auf. Zur Entkopplung der Steckkontakte untereinander dient nun das kammähnliche Schirmblech 2 gemäß der vorliegenden Erfindung. Dieses Schirmblech 2 ragt mit seinen Zinken 7 in in Querrichtung des Steckverbinders liegende Aufnahmekammern 5 hinein. Das Schirmblech 2 ist über stiftartige Vorsprünge 6 mit der Baugruppenleiterplatte 3 verbunden, d. h. an dieser befestigt. Über die stiftartigen Vorsprünge 6 erfolgt auch die Verbindung des Schirmblechs 2 mit einer Erdpotential Schicht auf der Baugruppenleiterplatte 3.

Innerhalb eines einzelnen Steckverbinders können beliebig viele Schirmbleche - je nach den gestellten elektrischen Anforderungen - angeordnet sein. Das Schirmblech 2 ermöglicht eine hochkapazitive und induktive Entkopplung der zu beiden Seiten des Schirmblechs angeordneten Steckkontakten.

## Patentansprüche

1. Steckverbinder für Rückwandverdrahtungen bestehend aus einer als einseitig offenes rechtwinkeliges Gehäuse ausgebildeten Messerleiste zum Aufstecken auf die Messer einer Rückwandleiterplatte und einer in die Messerleiste einsteckbaren mit Aufnahmekammern versehenen und mit einer Baugruppenleiterplatte festverbundenen Federleiste, wobei die Messer und Federn parallel in mehreren Reihen angeordnet sind, **dadurch gekennzeichnet,** daß in jeweils vorgegebenen Abständen quer zur Längsachse des Steckverbinders ein kammähnliches Schirmblech (2) angeordnet ist, dessen Zinken (7) in nebeneinanderliegende Aufnahmekammern (5) der Federleiste (1) hineinragen, und welches stiftartige Vorsprünge aufweist, die in gleicher Weise wie die Kontaktelemente (4) in Bohrungen der Baugruppenleiterplatte (3) eingesetzt sind.

## Revendications

1. Connecteur pour câblages de paroi arrière, constitué d'une réglette à couteaux, agencée sous la forme d'un boîtier rectangulaire ouvert d'un côté et destinée à s'enficher sur les couteaux d'une plaquette à circuits imprimés de paroi arrière et d'une réglette à ressorts, qui peut être enfichée dans la réglette à couteaux, qui est munie de chambres de réception et qui est reliée de façon fixe à la plaquette à circuits imprimés portant des modules, les couteaux et les ressorts étant disposés parallèlement en plusieurs rangées, caractérisé par le fait qu'à des distances respectives prédéterminées est disposée, transversalement à l'axe longitudinal du connecteur, une tôle de blindage (2) en forme de peigne, dont les dents (7) pénètrent dans des chambres de réception (5) côte-à-côte de la réglette à ressorts (1) et qui a des parties saillantes en forme de broches insérées de la même manière que les éléments de contact (4) dans des perçages de la plaquette à circuits imprimés (3) portant des modules.

## Claims

1. Plug-in connector for rear panel wiring, comprising a male multipoint connector, constructed as a rectangular housing open on one side, for plugging onto the blades of a rear panel board, and a female multipoint connector, which can be plugged into the male multipoint connector, is provided with receiving chambers and has a permanently connected module board, the blades and springs being arranged in parallel in a plurality of rows, characterized in that there is arranged at respectively prescribed intervals transverse to the longitudinal axis of the plug-in connector a comb-like shielding plate (2) whose prongs (7) project into juxtaposed receiving chambers (5) of the female multipoint connector (1), and which has pin-like projections which in the same way as the contact elements (4) are inserted in bores of the module board (3).
